Europäisches Patentamt

European Patent Office

Office européen des brevets

(11) Publication number: 0 209 642
A2

# EUROPEAN PATENT APPLICATION

(21) Application number: 86105160.5

(22) Date of filing: 15.04.86

(51) Int. Cl.4: H01L 23/04 , H01L 23/56

(30) Priority: 25.07.85 US 759527

(43) Date of publication of application:
28.01.87 Bulletin 87/05

(84) Designated Contracting States:
DE FR GB

(71) Applicant: Hewlett-Packard Company
Mall Stop 20 B-O 3000 Hanover Street
Palo Alto California 94304(US)

(72) Inventor: Pfeiffer, Greg D.
111 Junior Street
Santa Rosa CA. 95404(US)
Inventor: Read, Thomas L.
1065 Irwin Lane
Santa Rosa CA. 95401(US)

(74) Representative: Liesegang, Roland, Dr.-Ing.
Sckellstrasse 1
D-8000 München 80(DE)

(54) Ceramic microcircuit package.

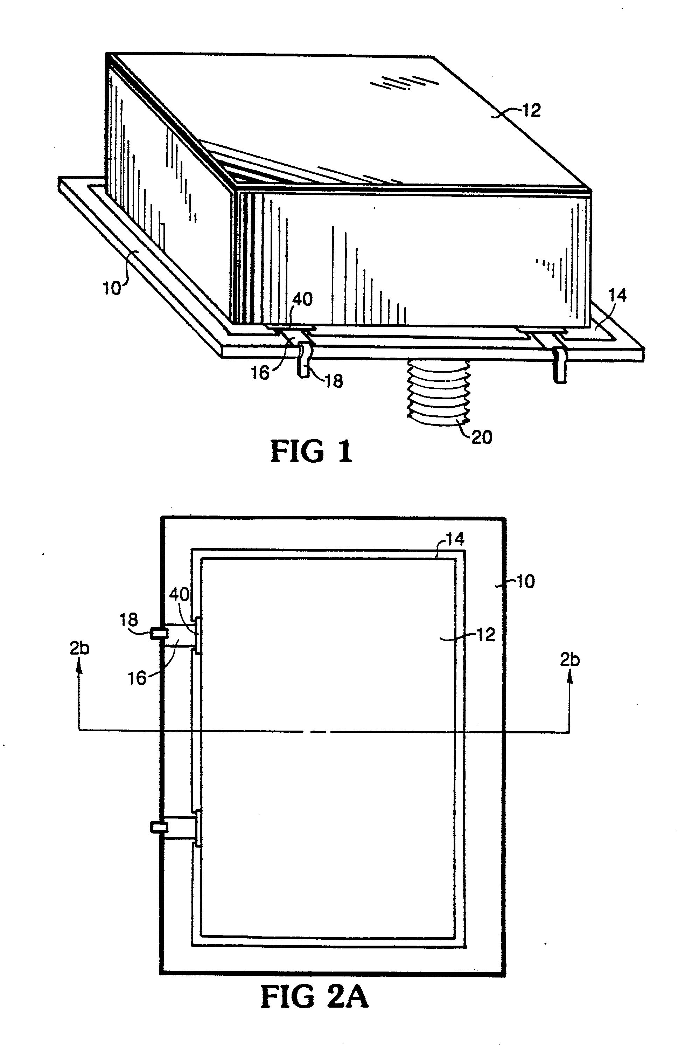

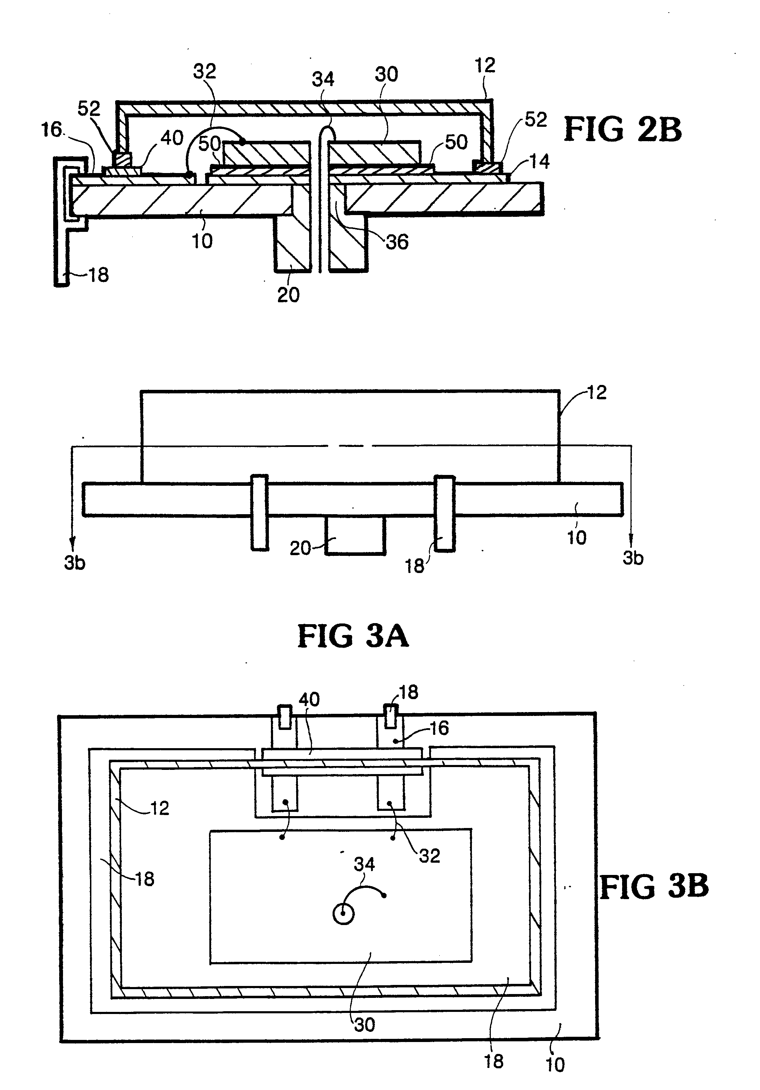

(57) A package for housing a microwave or RF microcircuit is disclosed. The package consists of a base (10) and a cover (12). The base (10) is constructed from a material that has the same thermal expansion coefficient as the microcircuit's substrate material. The base has an electrically conductive surface (14). The cover (12) is also electrically conductive. The cover (12) is adhered to the conductive surface (14) of the base (10), thus creating a package enclosure. Inside the package enclosure, the microcircuit (30) is adhered to the conductive surface (14) of the base (10). RF connectors (20), attached through the base (10), provide for transmission of RF signals. DC feed lines (16), applied to the base (10), provide for transmission of electrical signals (Fig. 2B).

FIG 2B

## Ceramic Microcircuit Package

Many microcircuits are adversely affected by dust, extreme temperatures, vibration, and humidity. Also, it is often critical that a microcircuit be shielded from outside electromagnetic radiation. By placing a microwave or RF microcircuit in a hermetically sealed package or container, the microcircuit can be insulated from these influences. Additionally, the package can act as a Faraday shield and suppress interference from electromagnetic radiation.

Traditional microwave or RF microcircuit packages consist of a flat base and a concave lid. The base and lid are usually machined from a metal, most commonly aluminum. The lid is generally attached to the base by a series of machine screws. The lid and base form an enclosure inside which a microcircuit is mounted. Most often, the microcircuit is attached to a carrier plate. This carrier plate, constructed from the same material the base is constructed from, is rigidly fastened to the base.

The microcircuit cannot be rigidly attached to the carrier plate. Due to dissimilar thermal expansion characteristics between the microcircuit and the carrier plate, the microcircuit must be attached to the carrier plate in such a way as to allow independent expansion while still restricting movement of the microcircuit. This is usually done through the use of finger clamps. A typical finger clamp is cut in a rectangular shape from a rigid material. One end of the finger clamp is rigidly fastened to the carrier plate. The other end of the finger clamp captures the microcircuit between itself and the carrier plate. While the finger clamps securely fasten the microcircuit inside the enclosure and permit dissimilar thermal expansion, they are bulky, heavy, and expensive.

Additionally, microcircuit packages must be constructed such that RF and DC signals can be transmitted to and from the microcircuit. This is accomplished by two structures: RF connectors and DC feed lines. RF connectors are usually coaxial connectors that are attached to the base. RF connectors are used when an impedance match is required between the input or output line and the microcircuit. They are referred to as RF connectors because the are typically used for supplying RF or microwave signals to and from the microcircuit. Traditional DC feed lines consist of a single wire passing from inside the package enclosure through the package base. These lines are insulated from the base by glass-to-metal seals. DC feed lines provide for supplying all other signals to and from the microcircuit. They are referred to as DC feed lines because they are typically used as power supply leads. Both the RF connectors and the DC feed lines are expensive.

The main object of the invention is to provide an inexpensive ceramic microcircuit package of the kind described above.

Particularly, expensive finger clamps for connection of the microcircuit to the carrier plate and expensive RF connectors and DC feed lines should be avoided.

Further the connection between the lid and the base should be simplified.

These and other objects of the invention are accomplished by the features of claim 1.

According to the preferred embodiment of the present invention, a ceramic microcircuit package is composed of a package base and a package lid. The package base and package lid form a package enclosure inside which a microcircuit is mounted. The package lid is concave and constructed from a metal. The package base is flat and constructed from the same material from which the microcircuit is constructed. A section of the package base is coated with a fero-magnetic ink to provide an electrically conductive ground plane.

The package lid is not bolted, but adhesively fastened to the base. If a Faraday shield is desired, the adhesive used must be capable of conducting electricity between the package lid and the ground plane. Since the base is made of the same material as is the microcircuit, no differential thermal expansion problems exist. Therefore, the microcircuit can be attached directly to the base. This eliminates the need for the carrier plate and its associated clamps, thereby reducing the size, weight, and cost of the ceramic microcircuit package.

As in the traditional package, RF connectors and DC feed lines are used to transmit signals to and from the microcircuit. The RF connectors used in the preferred embodiment are the same as the RF connectors that are used in the traditional package. The DC feed lines used in the preferred embodiment are different from the DC feed lines used in the traditional package. These DC feed lines are created by applying a conductive line onto the package base. These lines generally extend from inside the package enclosure to the edge of the base outside the package enclosure. In this way the microcircuit can be attached to the DC feed lines inside the package enclosure and transmit a DC signal outside the package enclosure.

Additionally, an integral bypass capacitor for the DC feed lines can be created. By applying a thick film dielectric ink between the DC feed lines and the package lid, a bypass capacitor is created.

Further details of the invention may be taken from the following description of a preferred embodiment of the invention at hand of the drawings in which:

Figure 1 shows the outside of a ceramic microcircuit package.

Figure 2a shows a top view of the ceramic microcircuit package.

Figure 2b shows a side view cross section of the ceramic microcircuit package.

Figure 3a shows a side view of the ceramic microcircuit package.

Figure 3b shows a top view cross section of the ceramic microcircuit package.

Figure 1 shows a microcircuit package that houses a microcircuit (not shown in this figure). The microcircuit package is composed of a package base 10 and a package lid 12. Package base 10 is constructed from alumina (A1203), the same material from which the microcircuit is constructed. Although this preferred embodiment discloses an alumina package base, any material with similar thermal expansion characteristics as the microcircuit could be used for the package base. For example beryllium oxide (BeO) or beryllia is an acceptable material for the package base. Package lid 12 is constructed from aluminum. Again, although this preferred embodiment discloses an aluminum package lid, any material or combination of materials with a magnetic shielding effectiveness of 35 dB or greater at 40 MHz can be used.

Package base 10 and package lid 12 form a package enclosure. The microcircuit is mounted inside the package enclosure on package base 10. A fero-magnetic ink is applied to package base 10 to form a ground plane 14. The fero-magnetic ink use to form ground plane 14 is ink paste DP-F560 that is sold by Ferro Corp in Santa Barbara, California. Although this preferred embodiment discloses Ferro Corp's ink paste DP-F560, any ink paste with a magnetic shielding effectiveness of 35 dB or greater at 40 MHz can be used. Package lid 12 is attached to ground plane 14 by a conductive adhesive 52 (shown in figure 2b). Adhesive 52 (shown in figure 2b), used to attach ground plane 14 to package lid 12, is conductive adhesive ECF-550 that is sold by Ablestick Inc. Although this preferred embodiment discloses Ablestick Inc.'s conductive adhesive ECF-550, any conductive adhesive with one mili-ohm of resistance per one half inch square area of application can be used.

A DC feed line 16 is also applied on package base 10. DC feed line 16 is a thick film ink capable of conducting electrical signals. DC feed line 16 extends from an edge of package base 10 to inside the package enclosure. An edge clip 18 is attached to DC feed line 16 at the edge of package base 10. Edge clip 18 is used to connect DC feed line 16 to an external device.

An RF connector 20 is attached through the bottom of package base 10. RF connector 20 is a coaxial connector. RF signals are transmitted to the microcircuit through RF connector 20.

Figure 2b shows a side sectional view and figure 3b shows a top sectional view of the microcircuit package. A microcircuit 30 is attached to ground plane 14 by a conductive adhesive 50 (not shown in figure 3b). Adhesive 50 (not shown in figure 3b), used to attach ground plane 14 to microcircuit 30, is conductive adhesive ECF-550 that is sold by Ablestick Inc. Again, although this preferred embodiment discloses Ablestick Inc.'s conductive adhesive ECF-550, any conductive adhesive with one mili-ohm of resistance per one half inch square area of application can be used. An outer conductor 36 of RF connector 20 (neither of which is shown in figure 3b) is also attached to ground plane 14. A central conductor 34 of RF connector 20 is attached to microcircuit 30. DC feed line 16 is connected to microcircuit 30 by a lead 32. Lead 32 carries DC signals to and from DC feed line 16. An external device can be attached to edge clip 18 to receive and supply DC signals.

A dielectric 40 is applied over DC feed line 16. Dielectric 40 is a thick film ink or other material that has a relative dielectric constant of greater than 400 at one KHz. Dielectric 40 performs two tasks. First, dielectric 40 allows package lid 12 to be attached over top of DC feed line 16 without grounding DC feed line 16 to ground plane 14. Second, by placing a dielectric material between two conductive materials, DC feed line 16 and package lid 12, an integral bypass capacitor is created.

## Claims

1. A package for a microcircuit formed on a substrate material, the package **characterized** by:

a package base means (10), constructed from a material having the same thermal expansion coefficient as the microcircuit substrate material, for providing a base for the package;

a shielding means (14), covering at least a portion of the package base means, for providing a conductive surface on which the microcircuit (30) can be attached; and an electrically conductive package lid means (12), conductively attached to the shielding means (14), for enclosing the microcircuit (30) between the package lid means and the shielding means to produce a package enclosure.

2. A device as in claim 1, **characterized** in that the shielding means (14) comprises a thick film ferro-magnetic ink.

3. A device as in claim 1, **characterized** in that the package base means further comprises:

an RF feed means (20,34,36) for carrying an RF signal; and

a DC feed means (16,18) for carrying an electrical signal.

4. A device as in claim 3, **characterized** in that the RF feed means comprises:

an RF connector (20), connected to the package base means (10), for receiving the RF signal, a via means (36) for providing a path through the package base means; and

an RF feed line means (34), that passes through the via means and that has two ends, the first end being connected to the RF connector and the second end being connected to the microcircuit (30), for supplying the RF signal to the microcircuit.

5. A device as in claim 3 or 4, **characterized** in that the DC feed means further comprise:

a feed line means (16), attached to the package base means (10) and having two ends, a first end located outside the package enclosure and a second end (32) located inside the package enclosure, for providing a DC feed line from outside the package enclosure into the package enclosure;

and an insulator means (40), placed between the feed line means (16) and the package lid means for insulating the feed line means from the package lid means (12) and for providing a bypass capacitor for the DC feed means.

6. A device as claimed in claim 5, **characterized** in that the feed line means further comprises an edge clip means (18), attached to the first end of the feed line means (16), for supplying a DC signal to the feed line means.

**FIG 1**

**FIG 2A**

FIG 2B

FIG 3A

FIG 3B